# EUROPEAN PATENT APPLICATION

(11) **EP 2 096 196 A1**
(43) Date of publication of application: **02.09.2009**
(21) Application number: 09002676.6
(22) Date of filing: 25.02.2009
(51) Int. Cl.: C30B 29/06, C30B 25/02, H01L 21/205

(54) **Method for manufacturing an epitaxial silicon wafer**

(30) Priority: 26.02.2008 US 31463 P
(71) Applicant: Siltronic AG, 81737 München (DE)
(72) Inventor: Lite, Kevin, 85579 Neubiberg (DE); Tran, Quynh, 98686 Vancouver, WA (US)
(74) Representative: Baar, Christian

(57) **Abstract**

An epitaxial silicon wafer is produced with a resistivity in the area adjacent the edge that is greater or less than the resistivity adjacent the center. The wafer may be manufactured by a method wherein one or more process parameters are adjusted during deposition of epitaxial layer to control the edge resistivity. Such process parameters may include using a nonhomogeneous temperature and/or a process reactant gas flow across the front surface of the wafer.

## Description

The present invention relates to method for manufacturing a silicon wafer with controlled edge resistivity.

An electronic device may be formed on a silicon wafer, e.g., a power device, such as a trench power MOSFET in an epitaxial layer on the silicon wafer. Such MOSFETS are typically designed and manufactured to meet certain specifications for a maximum "on" resistance (Rdson) and a minimum breakdown voltage (BV). A wafer parameter that affects Rdson and BV is the resistivity of the epitaxial layer. Ordinarily, resistivity is the subject of close monitoring during wafer processing, with specifications allowing no more than ±5% variation from a target value. The upper and lower limits of the variation ordinarily differ by the same percentage from the target value. Furthermore, resistivity is specified as uniform across the wafer.

During device processing, other factors, such as trench etch depth, polysilicon gate deposition, and lithographic definition, tend to be non-uniform across the wafer surface, and also affect BV within a given region.

The present disclosure is directed toward a method for producing a wafer where the resistivity of the epitaxial layer is controlled during processing to increase or decrease the resistivity in the area adjacent the edge of the wafer as compared to the area adjacent the center of the wafer. The target value for the resistivity may be raised or lowered in the area adjacent the edge, either in a single step or in multiple steps proceeding out from the center of the wafer. In such cases, a chart of the resistivity of a cross-section of the wafer passing through the wafer center will have a bowl-shape extending down from a high value in the area adjacent the left edge in the cross-section to a low point in the center of the cross-section, and back up to the high value in the area adjacent the right edge in the cross-section. The opposite situation is also possible whereby the edge resistivity is lower than that in the center of the wafer.

Process parameters may be adjusted during the deposition of the epitaxial layer to control the resistivity as described. For example a non-homogeneous temperature and/or a process reactant gas flow across the surface of the wafer may be used.

### Brief Description of the Drawings

Fig. 1 is a chart of a specification for epitaxial resistivity across a cross-section of a wafer for manufacture in accordance with the present disclosure. The opposite situation is also possible whereby the edge resistivity is lower than that in the center of the wafer.
Fig. 2 is an overhead view of the front surface of a wafer showing examples of the locations for measurements of resistivity.

### Detailed Description

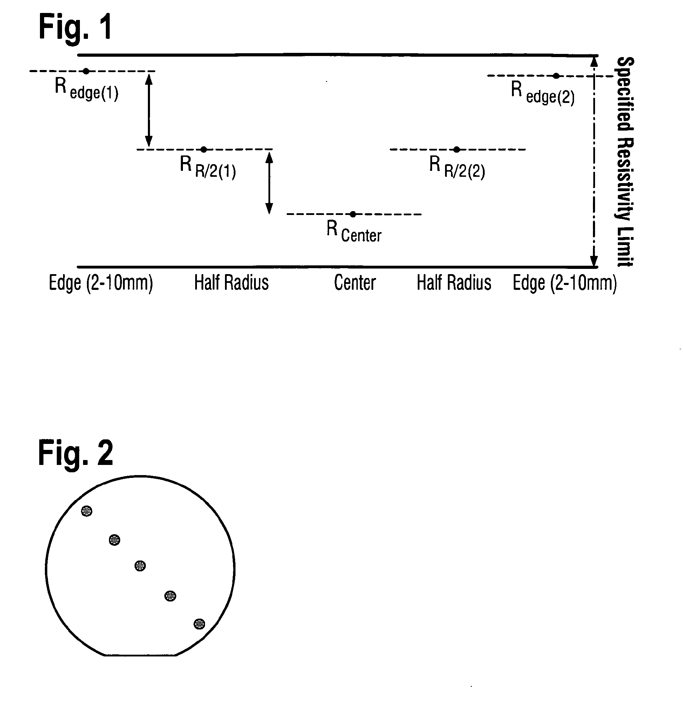

Fig. 1 shows a specification for resistivity in a wafer manufacturing process. The resistivity specification is shown for a cross-section intersecting the wafer's center. The x-axis of the chart represents the location on the wafer cross-section, starting at a first wafer edge, R_{edge(1)} at the left of the chart, passing through the wafer center (R_{center}) at the center of the chart, and ending at a second wafer edge, R_{edge(2)} at the right of the chart. Also indicated are the midpoints or half radii, R_{R/2(1)} and R_{R/2(2)}, on the wafer cross-section. The y-axis of the chart represents a target or limit value for resistivity. As noted in the background section, previous specifications for resistivity were understood to be uniform across the wafer.

In the present disclosure, resistivity is specified with differing values across the wafer. Resistivity (R_{edge(1)} and R_{edge(2)}) typically is greater in an area adjacent the edge of the wafer as compared to the resistivity (R_{center}) specified in the area adjacent the wafer center. The area adjacent the edge of the wafer is typically considered to be the area within about 2 mm to about 10 mm from the wafer edge, although smaller or larger areas may be used for optimization with other wafer parameters.

As shown in Fig. 1, the resistivity in the area adjacent the edge (R_{edge(1,2)}) may be increased or decreased by more than about 2% as compared to the resistivity at the wafer center (R_{center}). A greater or smaller increase or decrease in resistivity may be used as appropriate for reaching the results desired in a particular application of the present disclosure. Such increase for R_{edge(1,2)} can be at least about 6% as compared to R_{center}.

The specification may include a single change in resistivity from the wafer center to the edge or may include multiple stepped changes, or a linearly or otherwise changing resistivity from the center to the edge. For example, as shown in Fig. 1, the resistivity increases in two steps from the center to the edge. The first step is adjacent the half radius (R_{R/2(1)} and R_{R/2(2)}), and the second is adjacent the edge (R_{edge(1,2)}). Preferably, the value of the resistivity adjacent the half radius is between the value of the resistivity adjacent the center and the value of the resistivity adjacent the edge. Other locations for the steps may be selected as desired to tune wafer performance for the particular application and process parameters being used. Typical locations for measuring the resistivity, e.g., at the center, half-radius, and edges, are shown in Fig. 2. Additional steps beyond the two shown in Fig. 1 may also be used. The absolute and relative values of resistivity at each step may also be selected for desired performance in a particular application in accordance with the present disclosure.

Resistivity may be controlled by any suitable means during wafer processing. For example, selected process parameters may be adjusted during the deposition of the epitaxial layer to control the resistivity as described. Such parameters may include a non-homogeneous temperature and/or a process reactant gas flow across the surface of the wafer. For example, to increase the resistivity adjacent the edge, the temperature offset may be colder, typically between about 2ºC and about 10ºC colder. As another example, the resistivity adjacent the edge may be decreased by the temperature offset being hotter, typically between about 2ºC and about 10ºC hotter. Generally, a minor adjustment to resistivity is to be expected from a temperature offset of between about 2ºC and about 3ºC; a midrange adjustment to resistivity is to be expected from a temperature offset of between about 4ºC and about 6ºC; and a major adjustment to resistivity is to be expected from a temperature offset of between about 7ºC and about 10ºC. Other ranges may be used as suited to a particular application.

The resistivity may also be varied between the center and the edge by any other suitable means, e.g., by adjusting the gas injector flow distribution. This may be used to fine tune a gradient of resistivity between the center and the edge.

The resistivity may be controlled in any suitable type of deposition, such as vapor-phase epitaxy, chemical vapor deposition, or other manners of depositing an epitaxial layer. The deposition may be performed in any suitable reactor chamber or other device for producing an epitaxial layer. Preferably, the reactor is a single wafer reactor, which may also incorporate rotation of the wafer on a center axis. The reactor typically will have standard controls, such as lamp configuration, injector configuration, and others for the wafer to be adjusted from inside to outside.

Additionally, although the wafer with controlled resistivity and method for producing the same and features of that wafer and method have been shown and described with reference to the foregoing operational principles and preferred embodiments, those skilled in the art will find apparent that various changes in form and detail may be made without departing from the spirit and scope of the following claims. The present disclosure is intended to embrace all such alternatives, modifications, and variances that fall within the scope of such claims.

## Claims

1. A method for manufacturing a silicon wafer, the wafer defining a center, a circular outer edge, an area adjacent the edge, and a front surface, the method comprising:
depositing an epitaxial layer over the front surface of the wafer, the layer having a first resistivity adjacent the center, and a second resistivity in the area adjacent the edge, and
adjusting, during the step of depositing the epitaxial layer, at least one process parameter to control the second resistivity to be changed by at least about 2% compared to the first resistivity.

2. The method of claim 1 wherein the adjusting of the at least one process parameter includes using a non-homogeneous temperature.

3. The method of claim 1 wherein the adjusting of the at least one process parameter includes using a process reactant gas flow across the front surface of the wafer.

4. The method of claim 1 wherein the second resistivity is increased by at least about 2% compared to the first resistivity.

5. The method of claim 1 wherein the second resistivity is decreased by at least about 2% compared to the first resistivity.
